# EUROPEAN PATENT SPECIFICATION

(11) **EP 2 793 255 B1**
(45) Date of publication and mention of the grant of the patent: **06.12.2017**
(21) Application number: 13163861.1
(22) Date of filing: 16.04.2013
(51) Int. Cl.: H01L 21/8252, H01L 29/778, H01L 27/06, H01L 29/872, H01L 29/20, H01L 29/10, H01L 29/06, H01L 29/66

(54) **MANUFACTURING METHOD OF A SEMICONDUCTOR DEVICE COMPRISING A SCHOTTKY DIODE AND A HIGH ELECTRON MOBILITY TRANSISTOR**
HERSTELLUNGSVERFAHREN FÜR EINE HALBLEITERVORRICHTUNG MIT EINER SCHOTTKY-DIODE UND EINEM TRANSISTOR MIT HOHER ELEKTRONENMOBILITÄT
PROCÉDÉ DE FABRICATION D'UN DISPOSITIF SEMI-CONDUCTEUR COMPRENANT UNE DIODE SCHOTTKY ET UN TRANSISTOR À HAUTE MOBILITÉ D'ÉLECTRONS

(43) Date of publication of application: 22.10.2014
(73) Proprietor: IMEC, 3001 Leuven (BE)
(72) Inventor: Decoutere, Stefaan, 3001 Leuven (BE); Lenci, Silvia, 3001 Leuven (BE)
(74) Representative: Patent Department IMEC

(56) References cited:
- JP-A- 2007 109 830
- US-A1- 2008 090 368
- US-A1- 2009 166 677
- US-A1- 2011 042 719
- US-A1- 2011 193 171
- US-A1- 2011 233 615
- US-A1- 2011 254 056
- US-A1- 2012 146 093

## Description

### Field of the Invention

The present invention is related to semiconductor processing, in particular to processing of devices comprising a stack of III-nitride layers of different bandgaps, wherein charge carriers move in a 2-dimensional electron gas (2DEG) layer. The invention is in particular related to a method of producing a device comprising a Schottky diode and a High Electron Mobility Transistor (HEMT).

### State of the art.

Metal-semiconductor diodes, also referred to as Schottky diodes are widely used in rectifying circuits because of their low forward voltage drop and fast switching action. Schottky diodes produced on AlGaN/GaN heterostructures benefit from the high breakdown voltage of the GaN and the high mobility and high electron density of the 2DEG-layer appearing between the GaN and the AlGaN layer as a result of the difference of piezoelectric and spontaneous polarization. There is however the problem of high leakage current when the diode is reverse biased, with high power losses as a consequence. Another problem occurs when a Schottky diode of the above-described type is integrated on one substrate together with a High-Electron-Mobility Transistor (HEMT), that uses the same 2DEG for conducting charge. For a power diode, a lower turn-on voltage is desirable, in order to minimize the on-state voltage drop. However, a higher threshold voltage may be desirable for the AlGaN/GaN HEMT, which renders the diode/HEMT integration difficult.

Patent application US 2011/0233615 A1 discloses a GaN-based device comprising a transistor element and a rectifying element. Control electrodes of the rectifying element and of the transistor may comprise p-doped semiconductor material of different thicknesses.

Patent application US 2001/0254056 A1 also discloses a GaN-based device comprising a transistor and a rectifier. At least some of the control electrodes may comprise p-type semiconductor material of different thicknesses.

Patent application US 2011/0042719 A1 discloses a method of manufacturing GaN-based transistors comprising etching an opening into an insulating layer above an electron supply layer and growing p-type semiconductor material which forms part of a gate electrode.

### Summary of the invention

The invention is related to a method for producing a semiconductor device comprising a Schottky diode and a High Electron Mobility Transistor, the method comprising the steps of :
- producing a III-nitride stack on a carrier substrate 1, said stack comprising at least a lower and an upper III-nitride layer forming a heterojunction there between, so that a 2DEG layer may be formed in the lower of the two layers,
- Depositing a dielectric layer on said III-nitride stack,
- Patterning said dielectric layer to form a plurality of openings through the dielectric layer, corresponding to the location of the anode and cathode electrodes of the Schottky diode and to the location of the source, drain and gate electrodes of the HEMT, wherein the opening or openings corresponding to the location of said anode, hereafter referred to as 'anode-opening(s)', comprise a first portion corresponding to the Schottky junction of said diode and a second portion adjacent to said first portion, each opening of said second portion being located between the first portion and one of the opening or openings corresponding to the cathode electrode,

- Producing a first layer or layers of a doped III-nitride material in said second portion of the anode-opening or openings, and producing a second layer or layers of a doped III-nitride material in the opening or openings corresponding to the gate of said HEMT, hereafter referred to as 'gate opening(s)', wherein the thickness of said first and second layers (18,26) is not equal,
- Producing said anode and cathode electrodes and said source, gate and drain electrodes, a portion or portions of said anode being produced on top of said first layer or layers of a doped III-nitride material and the gate electrode being produced on top of said second layer or layers of a doped III-nitride material,
- Producing an isolation area between the diode and the HEMT.
In the above description of the method, an opening is said to be 'corresponding to' the location of an electrode when the opening is configured to receive at least a portion of the electrode metal, either by directly depositing metal in the opening or by depositing first one or more intermediate layers and depositing metal on said intermediate layer(s).

According to the invention, the step of producing said first and second layers of a doped III-nitride material is performed by selectively depositing a doped III-nitride material in said second portion of the anode-opening(s), and in the gate opening(s), said selective deposition taking place in a single deposition step, and wherein the dimensions of said second portion of the anode opening(s) and the dimensions of the gate-opening(s) are selected so that the thickness of the obtained first layer(s) is not equal to the thickness of the obtained second layer(s).

According to an embodiment, said openings of the second portion of the anode-opening(s) and said gate opening(s) have a length and wherein the length of said gate-opening(s) is smaller than the length of the opening(s) of said second portion of the anode opening(s), so that the thickness of said second layer (s) is higher than the thickness of said first layer(s).

According to an embodiment of the method, following the step of depositing a dielectric layer on the III nitride stack, the following subsequent steps are performed :
- forming said second portion of the anode-opening(s), and said gate opening(s) in a first step of patterning said dielectric layer,
- producing said first and second layer of doped III-nitride material in said second portion of the anode-opening(s), and in said gate opening(s),
- forming in a second patterning step said first portion of the opening(s) corresponding to the location of the anode of the Schottky diode,
- producing said anode electrode and said gate electrode,
- forming in one or more further patterning steps said openings corresponding to the location of the cathode electrode of the Schottky diode and of the source and drain electrodes of the HEMT,
- Producing said cathode electrode and said source and drain electrodes.

According to an embodiment, said lower III-nitride layer is a GaN layer, said upper III-nitride layer is an AlGaN layer, and said layers of doped III-nitride material are layers of p-doped GaN or AlGaN.

### Brief description of the figures

Figure 1 illustrates the structure of a device useful for understanding the present invention.
Figures 2a to 2i illustrate a number of steps in the method according to an embodiment of the invention.

### Detailed description of the invention

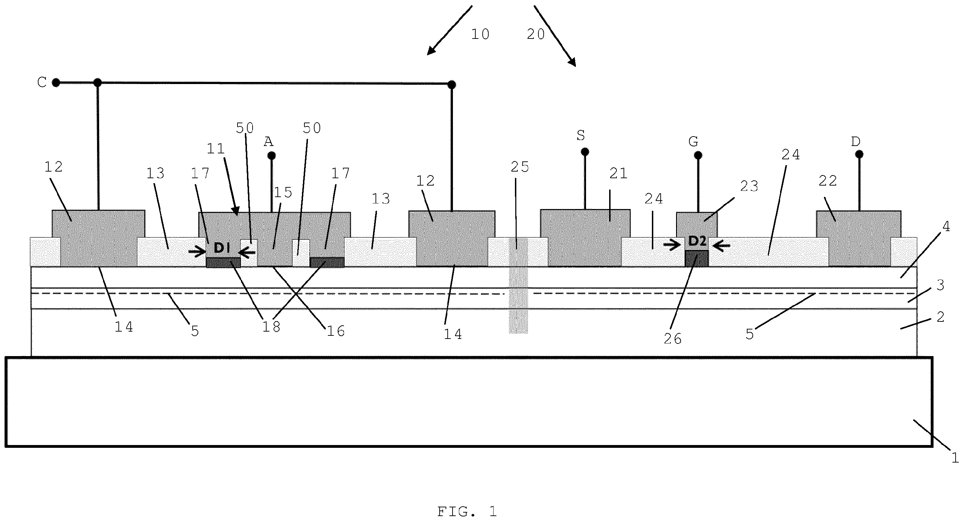

In a semiconductor device useful for understanding the invention, a Schottky power diode and a HEMT are arranged on the same substrate, and on the same stack of III-nitride materials, so as to conduct current via (portions of) the same 2DEG layers formed in said stack. In this detailed description, the 2DEG is described as formed between a GaN channel layer and a AlGaN barrier layer, even though other combinations of III-nitride layers may be suitable for the purpose of the invention. A device useful for understanding the invention is shown in figure 1. On a base substrate 1, e.g. a Si or Si-carbide substrate, the III-nitride stack is present, consisting of one or more buffer layers 2, a GaN channel layer 3 and an AlGaN barrier layer 4. The 2DEG 5 is formed at or near the interface between the channel layer and the barrier layer. The buffer layer 2 may be constituted by several (Al)GaN layers. It improves the buffer breakdown of the device, minimizes the mismatch between the substrate 1 and the GaN layer 3, and improves the confinement of the 2DEG at the AlGaN/GaN interface.

The diode 10 comprises a central anode 11 and symmetrically placed and externally interconnected cathodes 12. The anode and cathodes are elongate electrodes of a given width in the direction perpendicular to the drawing in figure 1. The anode and cathodes are connected to external terminals A and C respectively. Instead of separate and externally connected cathode portions 12, the cathode may also be a single electrode surrounding the anode, or the diode may have an asymmetrical structure with one anode and one cathode arranged side by side.

A dielectric layer 13 separates the anode and cathodes electrically from each other. The cathodes 12 are joined to the barrier layer 4 through ohmic contact junction 14. The anode comprises a central portion 15 that is joined to the barrier layer 4 through a Schottky barrier contact junction 16. The anode 11 further comprises lateral portions 17 that are separated from said barrier layer by a layer 18. This is a layer of p-doped GaN or p-doped AlGaN (we'll refer to it as a 'p-GaN layer' after this). The p-doping means that positive doping elements have been added to the GaN or AlGaN material. The p-doped layer applied in the invention is thus a layer with a higher doping level than an unintentionally doped layer, i.e. a layer containing unintentional impurities (e.g. oxygen and carbon), which are typically present at a doping level below 10¹³ at/cm³, and without intentionally added dopant atoms (typically Mg for positive doping). The effect of the p-doped area is to deplete the 2DEG layer when the diode is reverse biased, thereby blocking the reverse leakage current, whilst a high current conduction and low on-state voltage is obtained in forward conduction mode, through the Schottky junction 16. The effect of such a laterally placed p-doped region is known in itself, as illustrated for example by US2012/0146093.

The HEMT 20 comprises source and drain electrodes 21 and 22, in ohmic contact with the barrier layer 4, and a gate electrode 23. The electrodes are connected to external terminals S/D/C. Dielectric layers 24 isolate the electrodes from each other. A deeper isolation area 25 isolates the diode 10 from the HEMT 20. The gate electrode 23 is separated from the barrier layer 4 by a p-GaN or p-AlGaN layer 26 (again, we'll refer to it after this as a 'p-GaN layer'). The thickness of this layer 26 is different from the thickness of the p-GaN layers 18 provided in the diode structure. This difference in thickness is important for understanding the invention, as it is related to the turn-on voltage of the diode and the threshold voltage of the HEMT. By tuning these thicknesses in a suitable way, optimized turn-on and threshold voltages of the diode and HEMT respectively can be obtained. In the device illustrated in figure 1, the p-GaN layer 26 at the HEMT gate is thicker than the p-GaN layers 18 of the diode, thereby obtaining a predefined threshold voltage of the HEMT in accordance with the operative requirements of this HEMT device (conducting above a given gate bias voltage), while the turn-on voltage of the diode is lower due to a thinner p-GaN layer 18.

The p-GaN layer 18 shields the Schottky Barrier Diode from high reverse electric fields, by pinching off the channel when the anode-to-cathode voltage is lower than the turn-on voltage. Similarly, the p-GaN area 26 can pinch-off the transistor channel and allow transistor turn-off when the gate-to-source voltage is lower than the threshold voltage. Since the diode has to be a shorted connection in the on-state, a turn-on voltage as close as possible to zero is ideally targeted for the diode. Instead, a positive threshold voltage is wanted for the transistor, which must preferably show enhancement-mode behaviour (i.e. no 2DEG underneath the gate 23 unless a positive voltage is applied between the gate and source). Thus, the diode turn-on voltage must be lower than the transistor threshold voltage. In both cases, it is possible to tune the turn-on/threshold voltage by modifying the p-GaN thickness: increasing the p-GaN layer thickness results into a positive shift of turn-on/threshold voltage.

In the device of figure 1, all of the electrodes, p-GaN layers and dielectric isolation layers are shaped as elongate portions having a given width measured in the direction perpendicular to the drawing, and a given length in the plane of drawing and perpendicular to the width. The term 'length' is used as this particular dimension corresponds to the direction of current flow in the respective devices 10 and 20. As shown in figure 1, the length D2 of the layer 26 is smaller than the length D1 of the layers 18. This aspect is related to the preferred method according to the invention as described hereafter.

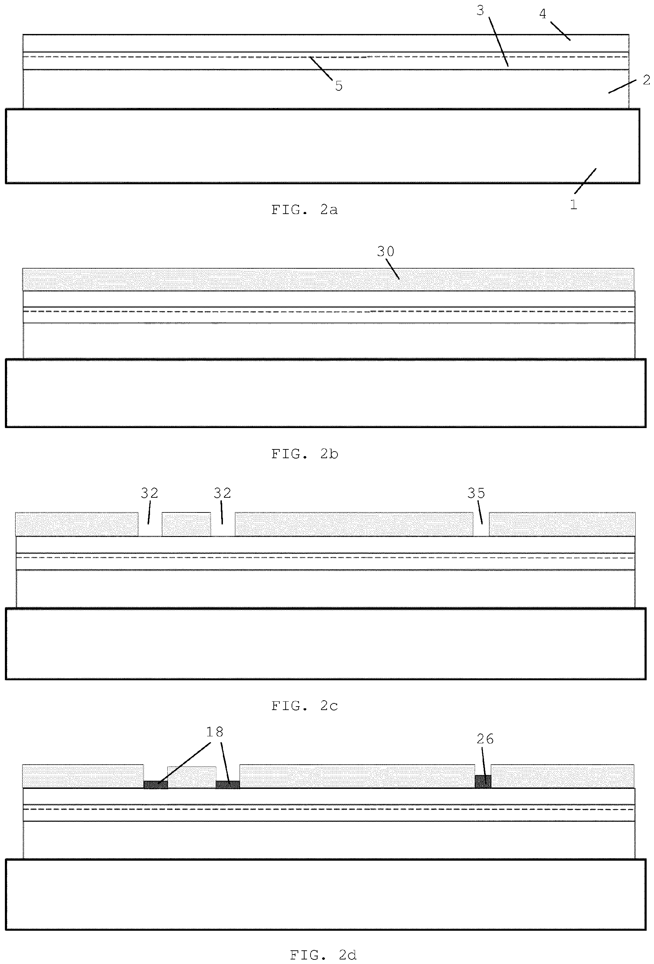

In general terms, the method of the invention for producing the device shown in figure 1 (with an AlGaN/GaN stack and layers 18 and 26 referred to as 'p-GaN layers', although the method is not limited to these particular combinations), comprises the following steps, illustrated in figures 2a to 2i:
- producing a III-nitride stack 2/3/4 as described above, on a carrier substrate 1. The production of such a III-nitride stack can be done according to any suitable technique known in the art, e.g. by Metal Organic Chemical Vapour Deposition (MOCVD). The barrier layer 4 is the top layer of the stack.
- Depositing a dielectric layer 30 on said III-nitride stack, for example a Si₃N₄ layer deposited in-situ (in the same process chamber as the III-nitride stack deposition) and for example by the same deposition process as the III-nitride stack. The dielectric layer may consist of several layers deposited sequentially.
- Patterning (e.g. by one or more standard litho/etch steps) said dielectric layer to form a plurality of openings 31 to 36 through the dielectric layer, corresponding to the locations 31 to 33 of the anode and cathode electrodes of the Schottky diode 10 and to the locations 34/35/36 of the source, gate and drain electrodes of the HEMT 20, wherein the opening or openings corresponding to said anode comprise a first portion 31 corresponding to the Schottky junction of said diode and at least one second portion 32 adjacent to said first portion, and located between the first portion 31 and the opening or openings 33 corresponding to the cathode. These openings are preferably not patterned in one litho/etch step, but in a series of such steps as described further in this description.

- Producing a first layer 18 of p-GaN in said second portion 32 of the anode-opening or openings, and producing a second layer of p-GaN 26 in the opening or openings 35 corresponding to the gate of said HEMT, wherein the thickness of said first and second layers is not equal,
- Producing said electrodes, for example by depositing electrically conductive layers and patterning said layers, a portion of said anode 11 being produced on top of the first p-GaN layer 18 and the gate electrode 23 being produced on top of the second p-GaN layer 26. Again, all electrodes are preferably not produced in a single step, but some electrodes may be produced after one or more first litho/etch steps, with other electrodes produced after further litho/etch steps, as described in the case of a preferred embodiment further in this description.
- Producing an isolation area 25 between the diode and the HEMT, e.g. produced by a mesa etch technique.
The production of the p-GaN layers 18 and 26 is preferably done by a deposition step of a GaN layer with in-situ doping, i.e. positive doping elements, such as Mg, are deposited during the GaN deposition step. At least one of the openings 32 and 35 wherein the first and second p-GaN layer 18/26 are to be deposited can be extended in the III-nitride stack, thereby recessing partially an upper III-nitride layer of the III-nitride stack.

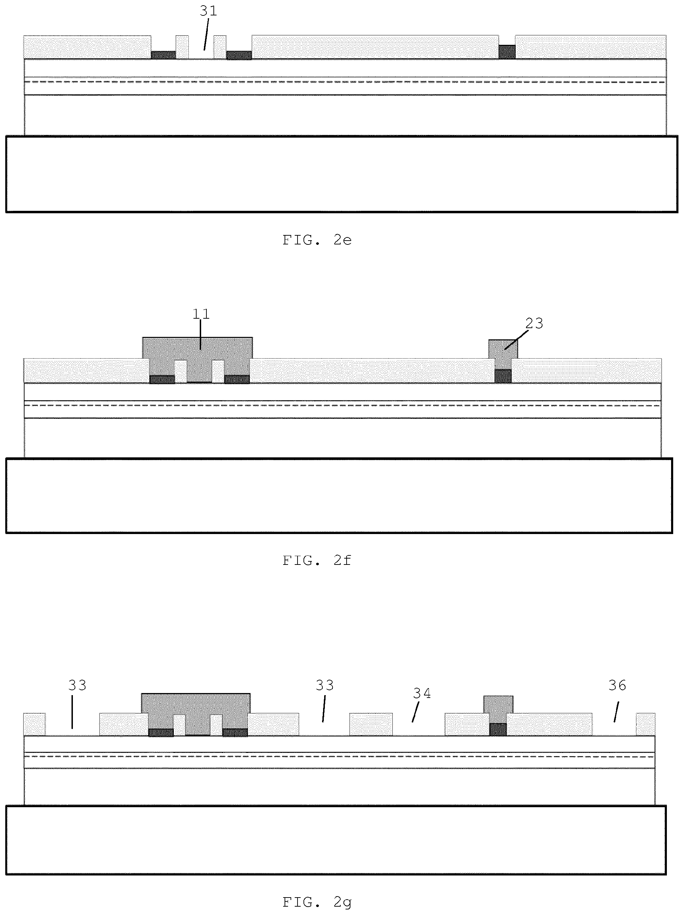

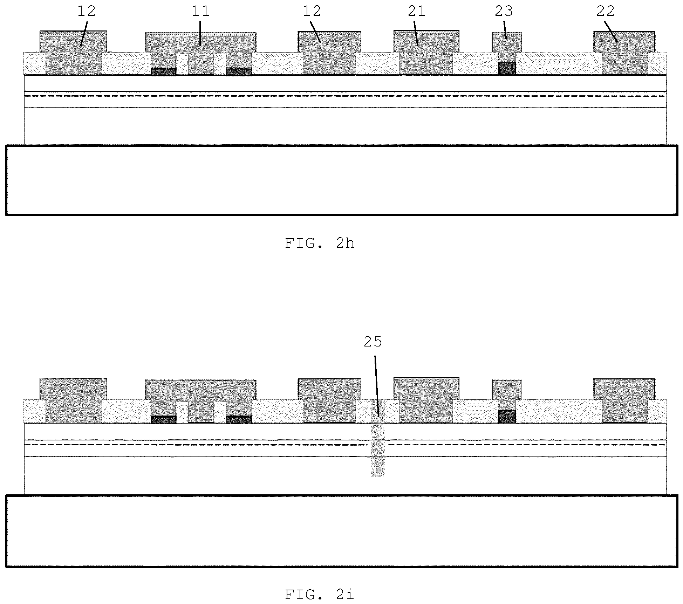

According to the preferred embodiment illustrated in figure 2, the openings 31-36 are not etched at the same time, nor are all the electrodes formed simultaneously. The openings 32 and 35 are formed first (fig. 2c), followed by the deposition of the p-GaN layers 18 and 26 (fig. 2d). Then opening 31 is formed (fig. 2e), followed by the deposition of electrodes 11 and 23 which could be made of different metals (fig 2f). Then a second litho/etch is performed for forming the openings 33, 34 and 36 (fig. 2g). This is followed by the production of the cathode electrode 12 and source and drain electrodes 21/22 in said openings (fig. 2h), and the formation of the isolation area 25 (fig. 2i).

According to the invention, the step of producing said first and second p-GaN layers 18/26 is performed in a single step, by selective deposition of the p-GaN in the openings 32/35 corresponding to the second anode portion and the HEMT gate. The selective deposition may be performed according to the known SAG technique (Selective Area Growth), with the dielectric layer 30 acting as the SAG mask.

Since the p-GaN layers 18/26 are deposited by simultaneous selective deposition as described above, the length D1 and D2 of the openings 32 and 35 is designed to obtain said different thicknesses. When the length of the opening is chosen smaller, the thickness of a selectively deposited p-GaN layer is thicker than the p-GaN deposited in a wider opening due to a loading effect during selective deposition. This tuning of the p-GaN thickness by a well-considered design of the dimensions of the openings is not known in the art today. Experiments by the inventors have revealed that selective p-GaN deposition simultaneously in a trench of 10µm in length and in a trench of 500nm in length, said trenches being produced in a Si₃N₄ layer, leads to a p-GaN layer of about 35nm thick in the wider trench and about 70nm thick in the narrower trench. This difference is sufficient for obtaining a shift of about 1V in the threshold voltage of the HEMT compared to the case where the thickness of the p-GaN layer would be 35nm both in the diode and in the HEMT. By adequately designing the length of the respective openings, it becomes possible to tune the turn-on and threshold voltages while the p-GaN layers in the diode and HEMT are produced in a single step.

The structure shown in figure 1 comprises active areas (such as anode, cathode and S/G/D electrodes) and separating isolation areas (13,24,25) of a given length, which is a commonly used layout for this type of device. The figure shows only one electrode of each type (except the cathode), but the device may consist of several electrode 'fingers' interconnected laterally by contact pads, as known in the art. The invention is furthermore not limited to producing this elongate shape of the electrodes but it is relevant to producing any other device structure.

The invention is not limited to producing the symmetric diode structure shown in figure 1, with a central anode and two cathodes. The diode may have one anode and one cathode with the p-GaN area 18 between the Schottky junction 16 of the diode and the ohmic junction 14 of the cathode.

The invention is furthermore not limited to producing the anode-structure shown in figure 1, wherein the Schottky junction 16 is separated from the p-GaN layers 18 by a dielectric area 50. In an alternative device produced by the inventive method, the p-GaN layer 18 may be directly adjacent and in contact with the Schottky junction 16.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

The foregoing description details certain embodiments of the invention. It will be appreciated, however, that no matter how detailed the foregoing appears in text, the invention may be practiced in many ways, and is therefore not limited to the embodiments disclosed. It should be noted that the use of particular terminology when describing certain features or aspects of the invention should not be taken to imply that the terminology is being re-defined herein to be restricted to include any specific characteristics of the features or aspects of the invention with which that terminology is associated.

Unless specifically specified, the description of a layer being deposited or produced 'on' another layer or substrate, includes the options of
- said layer being produced or deposited directly on, i.e. in contact with, said other layer or substrate, and
- said layer being produced on one or a stack of intermediate layers between said layer and said other layer or substrate.

## Claims

1. A method for producing a semiconductor device comprising a Schottky diode (10) and a High Electron Mobility Transistor (20), the method comprising the steps of :
- producing a III-nitride stack (2,3,4) on a carrier substrate 1, said stack comprising at least a lower and an upper III-nitride layer (3,4) forming a heterojunction there between, so that a 2DEG layer (5) may be formed in the lower of the two layers,
- Depositing a dielectric layer (30) on said III-nitride stack,
- Patterning said dielectric layer to form a plurality of openings through the dielectric layer, corresponding to the location (31,32,33) of the anode and cathode electrodes of the Schottky diode (10) and to the location (34,35,36) of the source, drain and gate electrodes of the HEMT (30), wherein the opening or openings corresponding to the location of said anode, hereafter referred to as 'anode-opening(s)', comprise a first portion (31) corresponding to the Schottky junction (16) of said diode and a second portion (32) adjacent to said first portion, each opening of said second portion (32) being located between the first portion (31) and one of the opening or openings (33) corresponding to the cathode electrode,
- Producing a first layer or layers (18) of a doped III-nitride material in said second portion (32) of the anode-opening or openings, and producing a second layer or layers (26) of a doped III-nitride material in the opening or openings (35) corresponding to the gate of said HEMT, hereafter referred to as 'gate opening (s)', wherein the thickness of said first and second layers (18,26) is not equal,
- Producing said anode and cathode electrodes (11,12) and said source, gate and drain electrodes (21,23,22), a portion or portions (17) of said anode being produced on top of said first layer or layers (18) of a doped III-nitride material and the gate electrode being produced on top of said second layer or layers (26) of a doped III-nitride material,
- Producing an isolation area (25) between the diode and the HEMT,
wherein the step of producing said first and second layers (18,26) of a doped III-nitride material is performed by selectively depositing a doped III-nitride material in said second portion (32) of the anode-opening(s), and in the gate opening(s) (35), said selective deposition taking place in a single deposition step, and wherein the dimensions of said second portion (32) of the anode opening (s) and the dimensions of the gate-opening (s) (35) are selected so that the thickness of the obtained first layer(s) (18) is not equal to the thickness of the obtained second layer(s) (26).

2. Method according to claim 1, wherein said openings of the second portion (32) of the anode-opening(s) and said gate opening(s) (35) have a length and wherein the length (D2) of said gate-opening (s) (35) is smaller than the length (D1) of the opening (s) of said second portion (32) of the anode opening(s), so that the thickness of said second layer (s) (26) is higher than the thickness of said first layer(s) (18).

3. Method according to any one of claims 1 and 2, wherein following the step of depositing a dielectric layer (30) on the III nitride stack, the following subsequent steps are performed :
- forming said second portion (32) of the anode-opening(s), and said gate opening(s) (35) in a first step of patterning said dielectric layer (30),
- producing said first and second layer (18,26) of doped III-nitride material in said second portion (32) of the anode-opening(s), and in said gate opening(s) (35),
- forming in a second patterning step said first portion (31) of the opening(s) corresponding to the location of the anode of the Schottky diode (10)
- producing said anode electrode (11) and said gate electrode (23),
- forming in one or more further patterning steps said openings (33,34,36) corresponding to the location of the cathode electrode of the Schottky diode (10) and of the source and drain electrodes of the HEMT (20),
- Producing said cathode electrode (12) and said source and drain electrodes (21,22).

4. Method according to any one of claims 1 to 3, wherein said lower III-nitride layer (3) is a GaN layer, said upper III-nitride layer is an AlGaN layer (4), and said layers of doped III-nitride material (18,26) are layers of p-doped GaN or AlGaN.

## Patentansprüche

1. Verfahren zur Herstellung einer Halbleitervorrichtung, die eine Schottky-Diode (10) und einen Transistor (20) mit hoher Elektronenmobilität umfasst, wobei das Verfahren die folgenden Schritte umfasst:
- Herstellen eines III-Nitridstapels (2,3,4) auf einem Trägersubstrat 1, wobei der Stapel mindestens eine untere und eine obere III-Nitridschicht (3, 4) aufweist, die dazwischen einen Heteroübergang bilden, so dass eine 2DEG-Schicht (5) in der unteren der beiden Schichten gebildet werden Kann,
- Abscheiden einer dielektrischen Schicht (30) auf dem III-Nitrid-Stapel,
- Mustern der dielektrischen Schicht, um mehrere Öffnungen durch die dielektrische Schicht zu bilden, die der Stelle (31, 32, 33) der Anoden- und Kathodenelektroden der Schottky-Diode (10) und der Stelle (34, 35, 36) der Source-, Drain- und Gate-Elektroden des HEMT (30) entsprechen, wobei die Öffnung oder Öffnungen, die der Stelle der Anode entsprechen und die im Folgenden als "Anoden-Öffnungen" bezeichnet werden, einen ersten Abschnitt (31), der dem Schottky-Übergang (16) der Diode entspricht, und einen zweiten Abschnitt (32) umfassen, der an den ersten Abschnitt angrenzt, wobei jede Öffnung des zweiten Abschnitts (32) zwischen dem ersten Abschnitt (31) und einer der Öffnung oder Öffnungen (33), die der der Kathodenelektrode entsprechen, angeordnet ist,
- Herstellen einer ersten Schicht oder Schichten (18) eines dotierten III-Nitridmaterials in dem zweiten Abschnitt (32) der Anodenöffnung oder -Öffnungen und Herstellen einer zweiten Schicht oder zweiter Schichten (26) aus einem dotierten III-Nitrid-Material in der Öffnung oder den Öffnungen (35), die dem Gate des HEMT entsprechen und die im Folgenden als "Gate-Öffnung(en) " bezeichnet werden, wobei die Dicke der ersten und der zweiten Schichten (18, 26) nicht gleich sind,
- Herstellen der Anoden- und Kathodenelektroden (11, 12) und der Source-, Gate- und Drain-Elektroden (21, 23, 22), wobei ein Abschnitt oder Abschnitte (17) der Anode auf der Oberseite der ersten Schicht oder Schichten (18) eines dotierten III-Nitridmaterials hergestellt wird bzw. werden, und wobei die Gate-Elektrode auf der Oberseite der zweiten Schicht oder Schichten (26) eines dotierten III-Nitridmaterials hergestellt wird,
- Herstellen eines Isolationsbereichs (25) zwischen der Diode und dem HEMT,
wobei der Schritt der Herstellung der ersten und zweiten Schichten (18, 26) eines dotierten III - Nitridmaterials durch selektives Abscheiden eines dotierten III-Nitridmaterials in dem zweiten Abschnitt (32) der Anodenöffnung(en) und in der bzw. den Gate-Öffnung(en) (35) durchgeführt wird, wobei die selektive Abscheidung in einem einzigen Abscheidungsschritt erfolgt, und wobei die Abmessungen des zweiten Abschnitts (32) der Anodenöffnung(en) und die Abmessungen der Gate-Öffnung(en) (35) so gewählt sind, dass die Dicke der erhaltenen ersten Schicht(en) (18) nicht gleich der Dicke der erhaltenen zweiten Schicht(en) (26) ist.

2. Verfahren nach Anspruch 1, wobei die Öffnungen des zweiten Abschnitts (32) der Anodenöffnung(en) und der Gate-Öffnung(en) (35) eine Länge aufweisen, und wobei die Länge (D2) der Gate-Öffnung(en) (35) kleiner als die Länge (D1) der Öffnung(en) des zweiten Abschnitts (32) der Anodenöffnung(en) ist, so dass die Dicke der zweiten Schicht(en) (26) größer als die Dicke der ersten Schicht(en) (18) ist.

3. Verfahren nach einem der Ansprüche 1 und 2, wobei nach dem Schritt des Abscheidens einer dielektrischen Schicht (30) auf dem III-Nitrid-Stapel die folgenden aufeinander folgenden Schritte durchgeführt werden:
- Bilden des zweiten Abschnitts (32) der Anodenöffnung(en) und der Gate-Öffnung(en) (35) in einem ersten Schritt des Musterns der dielektrischen Schicht (30),
- Herstellen der ersten und zweiten Schicht (18, 26) aus dotiertem III-Nitridmaterial in dem zweiten Abschnitt (32) der Anodenöffnung(en) und in der bzw. den Gate-Öffnung(en) (35),
- Bilden des ersten Abschnitts (31) der Öffnung(en), die der Stelle der Anode der Schottky-Diode (10) entspricht bzw. entsprechen, in einem zweiten Musterungsschritt,
- Bilden der Öffnungen (33, 34, 36), die der Stelle der Kathodenelektrode der Schottky-Diode (10) und der Source- und Drain-Elektroden des HEMT (20) entsprechen, in einem oder mehreren weiteren Musterungsschritten,
- Herstellen der Kathodenelektrode (12) und der Source- und Drain-Elektroden (21, 22).

4. Verfahren nach einem der Ansprüche 1 bis 3, wobei die untere III-Nitridschicht (3) eine GaN-Schicht ist, wobei die obere III-Nitridschicht eine AlGaN-Schicht (4) ist, und wobei die Schichten aus dotiertem III-Nitridmaterial (18, 26) Schichten aus p-dotiertem GaN oder AIGaN sind.

## Revendications

1. Procédé de fabrication d'un dispositif semi-conducteur comprenant une diode Schottky (10) et un transistor à haute mobilité d'électrons (20), le procédé comprenant les étapes suivantes :
- la fabrication d'un empilement de nitrure III (2, 3, 4) sur un substrat support (1), ledit empilement comprenant au moins une couche inférieure et une couche supérieure de nitrure III (3, 4) formant une hétérojonction entre elles, de sorte qu'une couche 2DEG (5) peut être formée dans la plus basse des deux couches,
- le dépôt d'une couche diélectrique (30) sur ledit empilement de nitrure III,
- le modelage de ladite couche diélectrique pour former une pluralité d'ouvertures à travers la couche diélectrique, correspondant à l'emplacement (31, 32, 33) des électrodes d'anode et de cathode de la diode Schottky (10) et à l'emplacement (34, 35, 36) des électrodes de source, de drain et de grille de l'HEMT (30), dans lequel l'ouverture ou les ouvertures correspondant à l'emplacement de ladite anode, ci-après appelée(s) « ouverture(s) d'anode », comprennent une première partie (31) correspondant à la jonction de Schottky (16) de ladite diode et une seconde partie (32) adjacente à ladite première partie, chaque ouverture de ladite seconde partie (32) étant située entre la première partie (31) et l'une parmi l'ouverture ou les ouvertures (33) correspondant à l'électrode de cathode,
- la fabrication d'une première/de premières couche(s) (18) d'un matériau de nitrure III dopé dans ladite seconde partie (32) de l'ouverture ou des ouvertures d'anode, et la fabrication d'une seconde/de secondes couche(s) (26) d'un matériau de nitrure III dopé dans l'ouverture ou les ouvertures (35) correspondant à la grille dudit HEMT, ci-après appelée(s) « ouverture(s) de grille », dans lequel l'épaisseur desdites première(s) et seconde(s) couches (18, 26) n'est pas égale,
- la fabrication desdites électrodes d'anode et de cathode (11, 12) et desdites électrodes de source, de grille et de drain (21, 23, 22), une partie ou des parties (17) de ladite anode étant fabriquées au-dessus de ladite/desdites première(s) couche(s) (18) d'un matériau de nitrure III dopé et l'électrode de grille étant fabriquée au-dessus de ladite/desdites seconde(s) couche(s) (26) d'un matériau de nitrure III dopé,
- la fabrication d'une zone d'isolation (25) entre la diode et l'HEMT,
dans lequel l'étape de fabrication desdites première et seconde couches (18, 26) d'un matériau de nitrure III dopé est effectuée en déposant sélectivement un matériau de nitrure III dopé dans ladite seconde partie (32) de l'ouverture/des ouvertures d'anode, et dans l'ouverture/les ouvertures de grille (35), ledit dépôt sélectif ayant lieu en une seule étape de dépôt, et dans lequel les dimensions de ladite seconde partie (32) de l'ouverture/des ouvertures d'anode et les dimensions de l'ouverture/des ouvertures de grille (35) sont sélectionnées de sorte que l'épaisseur de la/des première(s) couche(s) (18) n'est pas égale à l'épaisseur de la/des seconde(s) couche(s) (26) obtenue(s).

2. Procédé selon la revendication 1, dans lequel lesdites ouvertures de la seconde partie (32) de l'ouverture/des ouvertures d'anode et ladite/lesdites ouverture(s) de grille (35) ont une longueur et dans lequel la longueur (D2) de ladite/desdites ouverture(s) de grille (35) est plus petite que la longueur (D1) de l'ouverture/des ouvertures de ladite seconde partie (32) de l'ouverture/des ouvertures d'anode, de sorte que l'épaisseur de ladite/desdites seconde(s) couche(s) (26) est plus grande que l'épaisseur de ladite/desdites première(s) couche(s) (18).

3. Procédé selon l'une quelconque des revendications 1 et 2, dans lequel suite à l'étape de dépôt d'une couche diélectrique (30) sur l'empilement de nitrure III, les étapes consécutives suivantes sont effectuées :
- la formation de ladite seconde partie (32) de l'ouverture/des ouvertures d'anode, et de ladite/desdites ouverture(s) de grille (35) en une première étape de modelage de ladite couche diélectrique (30),
- la fabrication desdits première et seconde couches (18, 26) de matériau de nitrure III dopé dans ladite seconde partie (32) de l'ouverture/des ouvertures d'anode, et dans ladite/lesdites ouverture(s) de grille (35),
- la formation dans une seconde étape de modelage de ladite première partie (31) de l'ouverture/des ouvertures correspondant à l'emplacement de l'anode de la diode Schottky (10),
- la fabrication de ladite électrode d'anode (11) et de ladite électrode de grille (23),
- la formation en une ou plusieurs autres étapes de modelage desdites ouvertures (33, 34, 36) correspondant à l'emplacement de l'électrode de cathode de la diode Schottky (10) et des électrodes de source et de drain du HEMT (20),
- la fabrication de ladite électrode de cathode (12) et desdites électrodes de source et de drain (21, 22).

4. Procédé selon l'une quelconque des revendications 1 à 3, dans lequel ladite couche de nitrure III inférieure (3) est une couche de GaN, ladite couche de nitrure III supérieure est une couche d'AIGaN (4), et lesdites couches de matériau de nitrure III dopé (18, 26) sont des couches de GaN ou AIGaN dopé p.
